# EUROPÄISCHE PATENTANMELDUNG

(11) **EP 0 591 690 A2**
(43) Veröffentlichungstag der Anmeldung: **13.04.1994**
(21) Anmeldenummer: 93114277.2
(22) Anmeldetag: 06.09.1993
(51) Int. Cl.: G11C 16/06

(54) **Verfahren und Vorrichtung zur Programmierung eines nichtflüchtigen Speichers**

(30) Priorität: 08.10.1992 DE 4233822
(71) Anmelder: ROBERT BOSCH GMBH, 70442 Stuttgart (DE)
(72) Erfinder: Arnold, Herbert, Dipl.-Ing., D-71735 Eberdingen (DE); Mentgen, Dirk, Dipl.-Ing., D-71701 Schwieberdingen (DE)

(57) **Zusammenfassung**

Es wird ein Verfahren und eine Vorrichtung zur Programmierung eines nichtflüchtigen Speichers vorgeschlagen, bei dem der nichtflüchtige Speicher (13) in einer Anwendungsschaltung (11) eingesetzt ist. Für die Programmierung wird ein externes Programmiergerät (10) verwendet. Die einzelnen Anschlußleitungen (15) des nichtflüchtigen Speichers (13) werden mit dem Programmiergerät (10) verbunden. Sämtliche Sinale zur Programmierung des nichtflüchtigen Speichers (13) werden vom Programmiergerät (10) erzeugt und über Kontaktierungs- stifte (17) zu den Anschlußleitungen (15) des nichtflüchtigen Speichers (13) übertragen.

## Beschreibung

### Stand der Technik

Es ist schon ein Verfahren nach der Gattung des Hauptanspruchs aus der US 4 128 900 bekannt. Dabei wird ein nichtflüchtiger Speicher eines Steuergerätes programmiert. Das Steuergerät ist für die Steuerung einer Brennkraftmaschine vorgesehen. In dem Steuergerät ist ein Mikroprozessor und ein programmierbarer nichtflüchtiger Speicher enthalten. Die Programmierung des programmierbaren nichtflüchtigen Speichers (EPROM) findet am Bandende der Produktion des Steuergerätes statt. Dazu werden von einem externen Gerät auf einen Pin des Mikrorechners ein Takt-Signal und auf einen weiteren Pin des Mikrorechners die zu programmierenden Daten angelegt. Die Datenübertragung zum Mikrorechner findet seriell statt. An einen Pin des programmierbaren nichtflüchtigen Speichers wird eine Programmierspannung angelegt. Die Programmierung geht dabei so vonstatten, daß für jedes zu programmierende Datenwort ein Programmierbefehl, die Adresse der zu programmierenden Daten und die zu programmierenden Daten selbst an den Mikroprozessor übertragen werden. Der Mikroprozessor legt die Signale zur Einspeicherung der empfangenen Daten dann an den nichtflüchtigen Speicher an. Diese Lösung ist jedoch in mehrfacher Hinsicht relativ aufwendig.

### Vorteile der Erfindung

Das erfindungsgemäße Verfahren mit den kennzeichnenden Merkmalen des Hauptanspruchs hat demgegenüber den Vorteil, daß beim Steuergerät sowohl keine Schaltmittel als auch keine Programmieralgorithmen für die Programmierung des nichtflüchtigen Speichers mehr erforderlich sind. Es brauchen keine Anschlüsse für die Übertragung der zu programmierenden Daten zum Mikrorechner des Steuergerätes vorhanden sein. Als weiterer Vorteil ist anzusehen, daß die Programmierung bedeutend schneller stattfindet, da eine serielle Datenübertragung zum Mikrorechner des Steuergerätes entfällt und die Daten vom Programmiergerät direkt parallel in den Speicher eingeschrieben werden.

Durch die in den Unteransprüchen aufgeführten Maßnahmen sind vorteilhafte Weiterbildungen und Verbesserungen des im Hauptanspruch angegebenen Verfahrens möglich. So ist es vorteilhaft, daß während des Programmiervorganges des nichtflüchtigen Speichers vom Programmiergerät mindestens ein weiteres Signal, insbesondere ein Reset-Signal, erzeugt wird, welches über eine weitere Verbindung zu einer Anschlußleitung eines weiteren Bauteils, insbesondere eines Mikrorechners, der Anwendungsschaltung übertragen wird. Dadurch ist sichergestellt, daß das weitere Bauteil während des Programmiervorgangs nicht auf den nichtflüchtigen Speicher zugreift.

Für die Vorrichtung zur Durchführung des Verfahrens ist es vorteilhaft, daß das externe Programmiergerät an einen Kontaktierungsadapter anschließbar ist, daß in den Kontaktierungsadapter Stifte eingelassen sind, die auf Kontaktierungsstellen der Anschlußleitungen des nichtflüchtigen Speichers drücken, um das externe Programmiergerät mit den Anschlußleitungen des nichtflüchtigen Speichers zu verbinden. Damit ist die Verbindung zwischen Programmiergerät und Anwendungsschaltung schnell und sicher herstellbar.

Ebenfalls vorteilhaft ist es, daß der Kontaktierungsadapter weitere Stifte enthält, und daß mit den weiteren Stiften weitere Kontaktierungsstellen auf der Anwendungsschaltung mit dem Programmiergerät verbindbar sind. Damit ist es möglich, weitere Bauteile der Anwendungsschaltung in einen definierten Zustand zu versetzen, so daß Störeinflüsse von den weiteren Bauteilen der Anwendungsschaltung ausgeschlossen werden.

Ebenfalls vorteilhaft ist es, daß alle Stifte in ihrer Längsachse verschiebbar ausgeführt sind und durch eine Feder abgestützt sind. Wird dann der Kontaktierungsadapter gegen die Anwendungsschaltung gedrückt, ist ein sicherer Kontakt zwischen Anwendungsschaltung und Kontaktierungsadapter herstellbar und ebenfalls leicht lösbar.

Weiterhin vorteilhaft ist es, daß auf der Anwendungsschaltung mindestens ein Widerstand gegen ein Bezugspotential geschaltet ist, der eine mit ihm verbundene Kontaktierungsstelle vom Rest der Anwendungsschaltung entkoppelt. Dadurch ist es gewährleistet, daß die Signalpegel während des Programmiervorgangs nicht verzerrt werden.

Darüberhinaus ist es vorteilhaft, daß das externe Programmiergerät als modifiziertes Schaltungstestgerät ausgeführt ist, mit dem Fehler der Anwendungsschaltung feststellbar sind. Die Programmierung kann dann direkt nach dem Test der Anwendungsschaltung durchgeführt werden. Ein gesondertes Programmiergerät kann entfallen. Dies ist besonders vorteilhaft für die Produktion des Steuergerätes, da einige Arbeitsschritte für die Programmierung des Steuergerätes wie Transport zum gesonderten Programmiergerät, Kontaktierung mit dem gesonderten Programmiergerät, etc. entfallen können.

### Zeichnung

Ein Ausführungsbeispiel der Erfindung ist in der Zeichnung dargestellt und in der nachfolgenden Beschreibung näher erläutert. Es zeigen:
Figur 1 eine schematische Darstellung, wie Anwendungsschaltung, Kontaktierungsadapter und Programmiergerät miteinander verbunden sind;
Figur 2 ein Blockdiagramm einer konkreten Anwendungsschaltung und
Figur 3 einen Querschnitt durch den Kontaktierungsadapter.

### Beschreibung der Erfindung

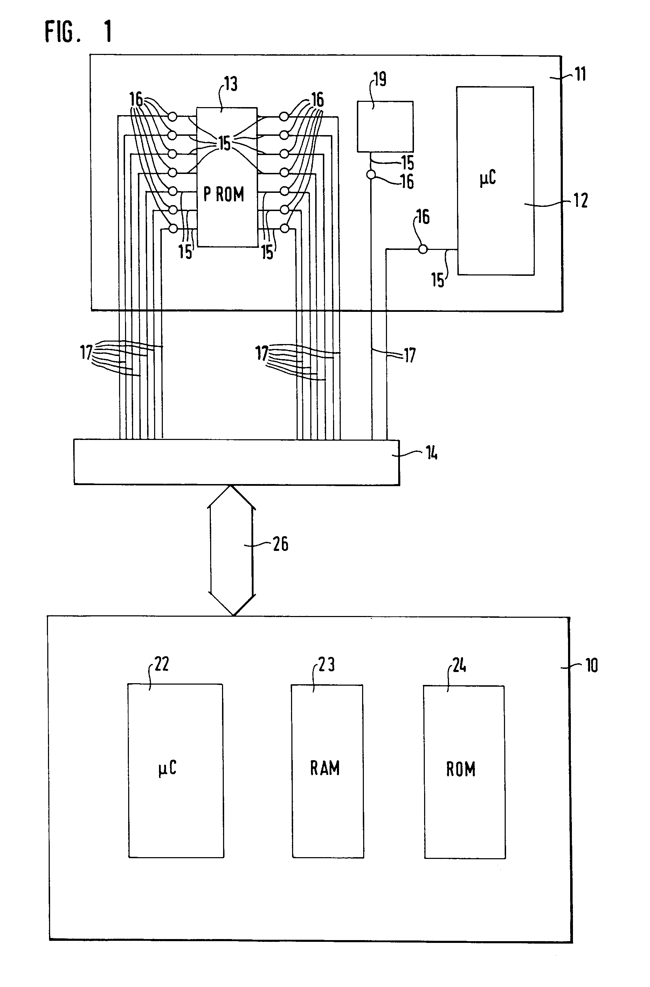

In der Figur 1 bezeichnet die Bezugszahl 10 ein Programmiergerät. Das Programmiergerät ist als Incircuit-Testgerät ausgeführt. Das Incircuit-Testgerät besitzt sowohl Mittel um einen Analogtest der Anwendungsschaltung durchzuführen, als auch Mittel, um einen Digitaltest der Anwendungsschaltung 11 durchzuführen. Beim Analogtest werden konkrete Bauelemente wie Widerstände, Kondensatoren, Spulen, Dioden, Transistoren, Operationsverstärker, etc. überprüft. Beim Digitaltest werden die IC's der Anwendungsschaltung 11 z.B. mit Hilfe von Testprogrammen überprüft. Wird ein Bauteil als fehlerhaft erkannt, so gibt das Incircuit-Testgerät eine entsprechende Fehlermeldung ab. Der konkrete Aufbau des Incircuit-Testgerätes wird im folgenden nur so weit beschrieben, wie er für die Erfindung wesentlich ist. Es kommt vor allem darauf an, daß das Incircuit-Testgerät ebenfalls als Programmiergerät verwendet wird. Es wird daher im folgenden nicht weiterhin vom Incircuit-Testgerät gesprochen, sondern der Ausdruck Programmiergerät verwendet. Das Programmiergerät 10 enthält einen Mikrorechner 22, ein RAM 23 und ein ROM 24. Im ROM 24 sind die Programmieralgorithmen und die einzuprogrammierenden Daten gespeichert. Das RAM 23 dient als Arbeitsspeicher. Es sind noch weitere Komponenten wie Ein-/Ausgabeschaltkreise, Adress-/Daten- und Steuerbus, etc. im Programmiergerät 10 enthalten, die aber der Einfachheit halber nicht dargestellt sind. Von dem Programmiergerät 10 führt ein Verbindungskabel 26 zu einem Kontaktierungsadapter 14. Von dem Kontaktierungsadapter 14 gehen Kontaktierungsstifte 17 zu Kontaktierungsstellen 16 auf die Anwendungsschaltung 11. Von den Kontaktierungsstellen 16 führen Anschlußleitungen 15 zu einem programmierbaren, nichtflüchtigen Speicher 13.

Die Anwendungsschaltung 11 enthält als weitere Bauelemente einen Mikrorechner 12 und ein Latch 19. Von dem Latch 19 und dem Mikrorechner 12 geht jeweils eine Anschlußleitung 15 zu jeweils einer weiteren Kontaktierungsstelle 20. Zu diesen Kontaktierungsstellen 20 führen vom Kontaktierungsadapter 14 weitere Kontaktierungsstifte 18.

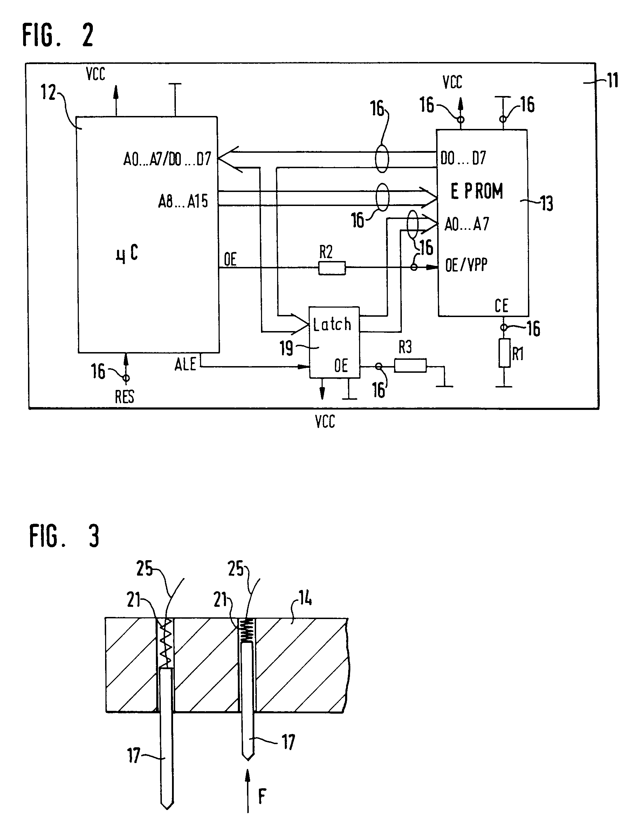

Die Funktionsweise der Anordnung nach Figur 1 wird im folgenden im Zusammenhang mit der Figur 2 beschrieben. In Figur 2 ist der Aufbau der Anwendungsschaltung 11 genauer dargestellt. Die Anwendungsschaltung 11 betrifft einen Rechnerkern von einem Motorsteuergerät für ein Kraftfahrzeug. Sie bildet die Hauptplatine des Motorsteuergerätes. Die Bezugszahl 12 bezeichnet den Mikrorechner des Steuergerätes. Als Mikrorechner 12 kann der kommerziell erhältliche SAB 80515 von der Firma Siemens in der Anwendungsschaltung eingesetzt sein. An den Mikrorechner 12 sind Versorgungsspannungsleitungen VCC und Masse angeschlossen. Von dem Mikrorechner 12 gehen Adress-/Datenleitungen A0 bis A7/D0 bis D7 zu dem programmierbaren nichtflüchtigen Speicher 13 und dem Latch 19. Diese Leitungen werden vom Mikrorechner 12 im Multiplexbetrieb angesteuert. Über diese Leitungen werden sowohl die Adress-Signale A0 bis A7 als auch die Datensignale D0 bis D7 übertragen. Dabei werden die Adress-Signale A0 bis A7 nur zum Latch 19 übertragen und die Datensignale D0 bis D7 nur vom programmierbaren nichtflüchtigen Speicher 13 zum Mikrorechner 12. Von dem Mikrorechner 12 gehen weiterhin Adressleitungen A8 bis A15 zum nichtflüchtigen Speicher 13. Vom Mikrorechner 12 geht eine Steuerleitung OE zu einem OE/VPP-Eingang des nichtflüchtigen Speichers 13. In die Steuerleitung OE ist ein Widerstand R2 geschaltet. Eine weitere Steuerleitung ALE geht vom Mikrorechner 12 zum Latch 19. Außerdem ist an dem Mikrorechner 12 eine Resetleitung RES angeschlossen. Von dem Latch 19 führen die Adressenleitungen A0 bis A7 zu dem nichtflüchtigen Speicher 13. An das Latch 19 sind ebenfalls Versorgungsspannungsleitungen VCC und Masse angeschlossen. Eine OE-Leitung führt vom Latch 19 zu einem Widerstand R3 und von dort nach Masse. An dem nichtflüchtigen Speicher 13 sind ebenfalls die Vorsorgungsspannungsleitungen VCC und Masse angeschlossen. Eine CE-Leitung führt vom nichtflüchtigen Speicher 13 zu einem Widerstand R1 und von dort nach Masse. Weitere Komponenten der Anwendungsschaltung 11, wie RAM, Signalaufbereitungsschaltungen für anschließbare Sensoren, Port- und Timer-Bausteine, etc. sind auf der Anwendungsschaltung 11 vorhanden aber ebenfalls der Einfachheit halber nicht dargestellt.

Für die Programmierung des nichtflüchtigen Speichers 13 wird die Anwendungsschaltung 11 über den Kontaktierungsadapter 14 von Figur 1 mit dem Programmiergerät 10 verbunden. Dabei drücken die Kontaktierungsstifte 17 auf die Kontaktierungsstellen 16 der Anwendungsschaltung 12. Typische Kontaktierungsstellen 16 sind die Lötstellen der Anwendungsschaltung 12. Der Kontaktierungsadapter 14 ist dabei für die Kontaktierung einer spezifischen Anwendungsschaltung 11 ausgelegt.

Der Programmiervorgang an sich findet dann wie folgt statt. Das Programmiergerät 10 legt an den nichtflüchtigen Speicher 13 die Versorgungsspannung VCC an. Ebenfalls legt das Programmiergerät 10 an den OE/VPP-Eingang des nichtflüchtigen Speichers 13 die Programmierspannung VPP an. Sie beträgt z.B. 12,75 V. Um zu verhindern, daß der Mikrorechner 12 während des Programmiervorgangs auf den nicht
flüchtigen Speicher 13 zugreift, legt das Programmiergerät 10 ein Reset-Signal an den RES-Eingang des Mikrorechners 12. Das Programmiergerät 10 legt ebenfalls die OE-Leitung des Latch 19 auf "Low"-Pegel. Das Programmiergerät 10 legt für die zu programmierende Speicherzelle die Adressen-Signale A0 bis A7 und A8 bis A15 an den nichtflüchtigen Speicher 13 an. Ebenfalls werden die Datenleitungen D0 bis D7 mit den Datensignalen für die zu programmierende Speicherzelle belegt. Über ein Signal auf der CE-Leitung wird die Zeit für den Programmiervorgang vorgegeben. Solange der CE-Eingang des nichtflüchtigen Speichers 13 "High"-Pegel hat, wird die über die Adressen-Signale angewählte Zelle programmiert. Nachdem der CE-Eingang wieder auf "Low"-Pegel geschaltet ist, legt das Programmiergerät 10 die Adressen- und Datensignale für die nächste zu programmierende Speicherzelle an. Der Programmiervorgang wird dann wiederholt. Auf diese Art und Weise werden alle zu programmierenden Daten in den nichtflüchtigen Speicher 13 programmiert. Die einzuprogrammierenden Daten können z.B. die gesamte Fahr-Software für das Motorsteuergerät darstellen. Da der Programmiervorgang von einem modifizierten Incircuit-Testgerät als Programmiergerät durchgeführt wird, können die einzuprogrammierenden Daten Korrekturdaten sein, durch die ein Softwareabgleich der Anwendungsschaltung 11 bewirkt wird. Dazu werden additive oder multiplikative Konstanten in den nichtflüchtigen Speicher 13 eingeschrieben. Diese gleichen dann die über den Incircuit-Test festgestellten Bauteildifferenzen aus. Anschließend werden alle programmierten Daten aus dem Speicher 13 ausgelesen und mit den Originaldaten im Programmiergerät 10 verglichen. Dabei nimmt das Programmiergerät 10 die Programmierspannung VPP vom nichtflüchtigen Speicher 13 zurück. Die Widerstände R1 bis R3 dienen zur Entkopplung der jeweiligen Anschlußleitungen vom Rest der Schaltung. Dadurch werden Störungen aufgrund von Rückkopplungen verhindert. Weitere Einzelheiten zu dem Programmiervorgang können den einschlägigen Datenbüchern für programmierbare nichtflüchtige Speicher entnommen werden.

In Figur 3 ist ein Ausschnitt des Kontaktierungsadapters 14 dargestellt. Es sind zwei Kontaktierungsstifte 17 in diesen Teil des Kontaktierungsadapters 14 eingelassen. Die Kontaktierungsstifte 17 sind dabei mit Federn 21 unterstützt. Jedem Kontaktierungsstift 17 ist eine Verbindungsleitung 25 zugeordnet, die zum Programmiergerät 10 führt. Über diese Verbindungsleitung 25 ist jeder Kontaktierungsstift 17 vom Programmiergerät 10 aus mit Signalen beaufschlagbar. Die Kontaktierungsstifte 17 können in ihrer Längsrichtung bewegt werden. Wird ein Kontaktierungsstift 17 mit einer Kraft F belastet, so wird die entsprechende Feder 21 zusammengedrückt. Der Kontaktierungsstift 17 wird so auf die Kontaktierungsstelle 16 aufgedrückt, daß ein sicherer Kontakt gewährleistet ist. Üblicherweise wird der Kontaktierungsadapter 14 gegen die Lötseite der Anwendungsschaltung 12 gedrückt.

Die Erfindung ist nicht auf das hier beschriebene Ausführungsbeispiel beschränkt. So ist es nicht unbedingt erforderlich, daß der Kontaktierungsadapter 14 von unten gegen die Anwendungsschaltung 12 drückt. Es ist ebenfalls denkbar, daß der Kontaktierungsadapter 14 von oben oder auch von beiden Seiten gegen die Anwendungsschaltung 12 drückt. Ebenfalls sind beim Programmieralgorithmus vielfältige Änderungen denkbar. Z.B. kann die Programmierzeit für eine einzelne Speicherzelle in mehrere kurze Abschnitte unterteilt sein. Nach jedem Abschnitt wird dann überprüft, ob die Speicherzelle schon vollständig beschrieben ist. Dadurch kann ggf. eine schnellere Programmierung erzielt werden. Bezüglich der einzuprogrammierenden Daten besteht keine Beschränkung. So kann durch das beschriebene Verfahren die gesamte Fahr-Software für das Motorsteuergerät in dem programmierbaren nichtflüchtigen Speicher 13 abgelegt werden. Es ist aber auch ebenfalls denkbar, daß nur einige wenige Kennungen zu diesem Zeitpunkt in den nichtflüchtigen Speicher einprogrammiert werden. Diese Kennungen können dann z.B. eine Seriennummer, aufgrund derer der
Produktionsort und die Produktionsbedingungen feststellbar sind, darstellen. Die Kennung kann aber ebenfalls vom Kunden, an den das Steuergerät ausgeliefert werden soll, vorgegeben sein. Sie dient dann z.B. als Kennzeichnung dafür, wohin das Steuergerät gesendet werden soll und bei welchem Fahrzeugtyp es eingesetzt werden soll.

## Patentansprüche

1. Verfahren zur Programmierung eines nichtflüchtigen Speichers, wobei der nichtflüchtige Speicher in eine Anwendungsschaltung, insbesondere eine Anwendungsschaltung für ein Steuergerät eines Kraftfahrzeuges, eingesetzt und verschaltet ist, mit einem externen Programmiergerät, dadurch gekennzeichnet, daß die einzelnen Anschlussleitungen (15) des nichtflüchtigen Speichers (13) mit dem externen Programmiergerät (10) lösbar verbunden werden, daß die Signale zur Programmierung des nichtflüchtigen Speichers (13) von dem Programmiergerät (10) erzeugt werden und über Verbindungen (17, 25) zu den Anschlussleitungen (15) des nichtflüchtigen Speichers (13) übertragen werden.

2. Verfahren nach Anspruch 1, dadurch gekennzeichnet, daß während des Programmiervorganges des nichtflüchtigen Speichers (13) vom Programmiergerät (10) mindestens ein weiteres Signal, insbesondere ein Resetsignal, erzeugt wird, das über mindestens eine weitere Verbindung (17) zu mindestens einer Anschlußleitung (15) mindestens eines weiteren Bauteils (12, 19) der Anwendungsschaltung (11) übertragen wird und daß durch das mindestens eine weitere Signal ein Zugriff des mindestens einen weiteren Bauteils (12, 19) zum nichtflüchtigen Speicher (13) verhindert wird.

3. Vorrichtung zur Durchführung des Verfahrens nach einem der vorhergehenden Ansprüche mit einem nichtflüchtigen Speicher, wobei der nichtflüchtige Speicher in eine Anwendungsschaltung, insbesondere eine Anwendungsschaltung für ein Steuergerät eines Kraftfahrzeuges, eingesetzt und verschaltet ist, mit einem externen Programmiergerät, dadurch gekennzeichnet, daß das externe Programmiergerät (10) an einen Kontaktierungsadapter (14) anschließbar ist, daß in den Kontaktierungsadapter (14) Stifte (17) eingelassen sind, die auf Kontaktierungsstellen (16) der Anschlußleitungen (15) des nichtflüchtigen Speichers (13) drücken, um das externe Programmiergerät (10) mit den Anschlußleitungen (15) des nichtflüchtigen Speichers (13) zu verbinden.

4. Vorrichtung nach Anspruch 3, dadurch gekennzeichnet, daß der Kontaktierungsadapter (14) weitere Stifte (17) enthält, daß mit den weiteren Stiften (17) weitere Kontaktierungsstellen (16) auf der Anwendungsschaltung (11) mit dem Programmiergerät (10) verbindbar sind, die zu weiteren Bauteilen (12, 19) der Anwendungsschaltung (11) führen.

5. Vorrichtung nach Anspruch 3 oder 4, dadurch gekennzeichnet, daß die Stifte (17) in der Längsachse verschiebbar ausgeführt sind und gegen eine Feder (21) abgestützt sind.

6. Vorrichtung nach einem der Ansprüche 3 bis 5, dadurch gekennzeichnet, daß auf der Anwendungsschaltung (12) mindestens ein Widerstand (R1,R2,R3) gegen ein Bezugspotential geschaltet ist, der eine mit ihm verbundene Kontaktierungsstelle (16) vom Rest der Anwendungsschaltung (12) entkoppelt.

7. Vorrichtung nach einem der Ansprüche 3 bis 6, dadurch gekennzeichnet, daß das externe Programmiergerät (10) als modifiziertes Schaltungstestgerät ausgeführt ist, mit dem Fehler der Anwendungsschaltung (11) feststellbar sind.
